# EUROPEAN PATENT APPLICATION

(11) **EP 4 761 543 A2**
(43) Date of publication of application: **17.06.2026**
(21) Application number: 25203431.9
(22) Date of filing: 19.09.2025
(51) Int. Cl.: H10K 59/35

(54) **DISPLAY PANEL AND ELECTRONIC DEVICE INCLUDING THE SAME**

(30) Priority: 12.12.2024 KR 20240184522
(71) Applicant: Samsung Display Co., Ltd., Yongin-si, Gyeonggi-do 17113 (KR)
(72) Inventor: JEONG, Da-Hee, 17113 Yongin-si (KR)
(74) Representative: Marks & Clerk LLP

(57) **Abstract**

A display panel includes upper pixels and lower pixels, each including: a first sub-pixel, which emits first light; a second sub-pixel, which emits second light; and a third sub-pixel, which emits third light having a wavelength longer than that of the first light and shorter than that of the second light. A distance between two closest first sub-pixels is defined as a first distance, a distance between two closest second sub-pixels is defined as a second distance, and a distance between two closest third sub-pixels is defined as a third distance. The first distance and the second distance are each shorter than the third distance, an internal region is defined between the two closest third sub-pixels, and no light or fourth light is emitted from the internal region, and the fourth light is different from the first, second and second lights.

## Description

### BACKGROUND

### 1. Technical Field

The present disclosure relates to a display panel and an electronic device including the same. Specifically, the disclosure pertains to a display panel in which some sub-pixels are arranged adjacent to each other, while other sub-pixels are arranged non-adjacently, and an electronic device including such a display panel.

### 2. Description of the Related Art

A display panel includes a plurality of pixels, each of which consists of sub-pixels that emit red light, sub-pixels that emit blue light, and sub-pixels that emit green light. The aforementioned sub-pixels are manufactured through a deposition process, during which a mask is used to fabricate each sub-pixel.

The mask has apertures corresponding to each sub-pixel defined therein, and to achieve a display panel with higher resolution, a mask with smaller apertures is required. However, as the aperture size of the mask decreases, the difficulty and cost of manufacturing such a mask increase, posing a significant challenge.

### SUMMARY

An aspect of the present disclosure is to address the aforementioned issues by arranging sub-pixels that emit red light adjacent to each other and arranging sub-pixels that emit blue light, thereby enlarging the apertures of the mask.

Another aspect of the present disclosure is to prevent a reduction in visibility by arranging sub-pixels that emit red light and blue light adjacent to each other and not arranging sub-pixels that emit green light adjacent to each other.

A display panel according to an embodiment of the present disclosure includes a first pixel group, a second pixel group, and a third pixel group. The first, second, and third pixel groups are adjacent to each other. A plurality of sub-pixel regions that do not overlap each other in a plan view are defined in each of the first, second, and third pixel groups. Among the plurality of sub-pixel regions defined in the first pixel group, light of different wavelengths is emitted from the two closest sub-pixel regions, or no light may be emitted from one of the two closest sub-pixel regions. A first sub-pixel region among the plurality of sub-pixel regions defined in the first pixel group is closest to a second sub-pixel region among the plurality of sub-pixel regions defined in the second pixel group. The same light of first light and second light is emitted from each of the first sub-pixel region defined in the first pixel group and the second sub-pixel region defined in the second pixel group. A third region among a plurality of sub-pixel regions defined in the first pixel group is closest to a fourth sub-pixel region among a plurality of sub-pixel regions defined in the third pixel group. The third sub-pixel region is configured to emit third light. No light is emitted from the fourth sub-pixel region, or fourth light is emitted from the fourth sub-pixel region. The wavelength of the third light is longer than the wavelength of the first light and shorter than the wavelength of the second light, and the fourth light differs from the first, second, and third lights.

In an embodiment of the present disclosure, the first pixel group may include a first upper pixel and a first lower pixel facing each other. The second pixel group may include a second upper pixel and a second lower pixel facing each other. The third pixel group may include a third upper pixel and a third lower pixel facing each other. Each of the first to third upper pixels may include first to third sub-pixels, and each of the first to third lower pixels may include first to third sub-pixels. The first sub-pixel may be configured to emit first light, the second sub-pixel may be configured to emit second light, and the third sub-pixel may be configured to emit third light.

The first sub-pixel of the first upper pixel and the first sub-pixel of the second lower pixel may be arranged, respectively, in the first sub-pixel region and the second sub-pixel region, or the second sub-pixel of the first upper pixel and the second sub-pixel of the second lower pixel may be arranged, respectively, in the first sub-pixel region and the second sub-pixel region. The third sub-pixel of the first upper pixel may be arranged in the third sub-pixel region. At least one of the plurality of sub-pixel regions of each of the first to third upper and lower pixels may be an internal region. In the internal region, no light may be emitted, or the fourth light may be emitted. The fourth sub-pixel region may be an internal region of the third lower pixel.

The display panel according to an embodiment of the present disclosure may further include at least one of a predetermined material, a sensor, and a fourth sub-pixel. At least one of the predetermined material, sensor, and fourth sub-pixel may be arranged in the internal region. The predetermined material may allow at least a portion of the incident light to transmit, and the fourth sub-pixel may be configured to emit the fourth light.

In an embodiment of the present disclosure, each of the first to third upper pixels and each of the first to third lower pixels may further include the fourth sub-pixel. The fourth sub-pixel may be configured to emit the fourth light and may be disposed in the internal region.

In an embodiment of the present disclosure, the first pixel group may be arranged within a first pixel group region having a hexagonal shape, and the second pixel group may be arranged within a second pixel group region having a hexagonal shape. The third pixel group may be arranged within a third pixel group region having a hexagonal shape.

In an embodiment of the present disclosure, the first upper pixel may be positioned between the first lower pixel and the third lower pixel, and the third lower pixel may be positioned between the first upper pixel and the third upper pixel.
A display panel according to another embodiment of the present disclosure includes a first pixel group, a second pixel group, and a third pixel group. The first, second, and third pixel groups are adjacent to each other, and a plurality of sub-pixel regions that do not overlap with one another in a plan view are defined within each pixel group. Light of different wavelengths is emitted from the two closest sub-pixel regions among the plurality of sub-pixel regions defined in the first pixel group, or no light is emitted from one of the two closest sub-pixel regions. A first sub-pixel region among the plurality of sub-pixel regions defined in the first pixel group is positioned to face a second sub-pixel region among the plurality of sub-pixel regions defined in the second pixel group. The same light of first light and second light is emitted from each of the first sub-pixel region defined in the first pixel group and the second sub-pixel region defined in the second pixel group. A third sub-pixel region among the plurality of sub-pixel regions defined in the first pixel group is positioned to face a fourth sub-pixel region among the plurality of sub-pixel regions defined in the third pixel group. the third sub-pixel region is configured to emit third light. No light or fourth light is emitted from the fourth sub-pixel region. The wavelength of the third light is longer than the wavelength of the first light and shorter than the wavelength of the second light. The fourth light differs from the first, second, and third lights.
In an embodiment, the first pixel group may include a first upper pixel and a first lower pixel facing each other. The second pixel group may include a second upper pixel and a second lower pixel facing each other. The third pixel group may include a third upper pixel and a third lower pixel facing each other. Each of the first to third upper pixels and each of the first to third lower pixels may include first to third sub-pixels. The first sub-pixel may be configured to emit first light, and the second sub-pixel may be configured to emit second light. The third sub-pixel may be configured to emit third light. The first sub-pixel of the first upper pixel and the first sub-pixel of the second lower pixel may be disposed in the first sub-pixel region and the second sub-pixel region, respectively, or the second sub-pixel of the first upper pixel and the second sub-pixel of the second lower pixel may be disposed in the sub-pixel region and the second sub-pixel region, respectively. The third sub-pixel of the first upper pixel may be arranged in the third sub-pixel region. At least one of the plurality of sub-pixel regions of each of the first to third upper and lower pixels may be an internal region where no light or fourth light is emitted. The fourth sub-pixel region may be an internal region of the third lower pixel.

The display panel may further include at least one of a predetermined material, a sensor, and the fourth sub-pixel. At least one of the predetermined material, the sensor, and the fourth sub-pixel may be disposed in the internal region. The predetermined material may be configured to allow at least a portion of the incident light to transmit, and the fourth sub-pixel may be configured to emit the fourth light.

In the display panel according to the present embodiment, each of the first to third upper pixels and the first to third lower pixels may further include the fourth sub-pixel. The fourth sub-pixel may be configured to emit the fourth light and may be disposed in the internal region.

The first pixel group may be arranged within a first pixel group region having a hexagonal shape, the second pixel group may be arranged within a second pixel group region having a hexagonal shape, and the third pixel group may be arranged within a third pixel group region having a hexagonal shape.

The first upper pixel may be positioned between the first lower pixel and the third lower pixel, and the third lower pixel may be positioned between the first upper pixel and the third upper pixel.
A display panel according to yet another embodiment of the present disclosure includes a plurality of upper pixels and a plurality of lower pixels. Each of the plurality of upper pixels and each of the plurality of lower pixels includes a first sub-pixel, a second sub-pixel, and a third sub-pixel. The first sub-pixel is configured to emit first light. The second sub-pixel is configured to emit second light. The third sub-pixel is configured to emit third light, which has a wavelength that is longer than a wavelength of the first light and shorter than a wavelength of the second light. The distance between the two closest first sub-pixels among the plurality of first sub-pixels is defined as a first distance. The distance between the two closest second sub-pixels among the plurality of second sub-pixels is defined as a second distance. The distance between the two closest third sub-pixels among the plurality of third sub-pixels is defined as a third distance. Each of the first and second distances is shorter than the third distance. An internal region is defined between the two closest third sub-pixels. In the internal region, no light is emitted, or fourth light, which differs from the first, second, and third lights, is emitted.

The display panel may further include at least one of a predetermined material, a sensor, and a fourth sub-pixel. At least one of the predetermined material, sensor, and fourth sub-pixel may be arranged in the internal region. The predetermined material may be configured to allow at least a portion of the incident light to transmit, and the fourth sub-pixel may be configured to emit the fourth light.

In the display panel according to the present embodiment, each of the plurality of upper pixels and the plurality of lower pixels may further include a fourth sub-pixel, which emits fourth light. At least one of the plurality of fourth sub-pixels may be disposed in the internal region.

The first upper pixel among the plurality of upper pixels may be closest to the first lower pixel among the plurality of lower pixels. The first upper pixel and the first lower pixel may be arranged within a first pixel group region having a hexagonal shape. The second upper pixel among the plurality of upper pixels may be closest to the second lower pixel among the plurality of lower pixels. The second upper pixel and the second lower pixel may be arranged within a second pixel group region having a hexagonal shape. The third upper pixel among the plurality of upper pixels may be closest to the third lower pixel among the plurality of lower pixels. The third upper pixel and the third lower pixel may be arranged within a third pixel group region having a hexagonal shape.

The first upper pixel may be positioned between the first lower pixel and the third lower pixel. The third lower pixel may be positioned between the first upper pixel and the third upper pixel.
A display panel according to still another embodiment of the present disclosure includes a first upper pixel, a first lower pixel, a second lower pixel, and a third lower pixel. Each of the first upper pixel, first lower pixel, second lower pixel, and third lower pixel includes a first sub-pixel configured to emit first light, a second sub-pixel configured to emit second light, and a third sub-pixel configured to emit third light, which has a wavelength that is longer than that of the first light and shorter than that of the second light. An internal region is defined in each of the first upper pixel, first lower pixel, second lower pixel, and third lower pixel. **In** the internal region, no light is emitted, or fourth light, which differs from the first, second, and third lights, is emitted. The first sub-pixel of the first upper pixel is positioned to face the second sub-pixel of the first lower pixel. The second sub-pixel of the first upper pixel is positioned to face the first sub-pixel of the first lower pixel. The internal region defined in the first upper pixel is positioned to face the third sub-pixel of the first lower pixel. The first sub-pixel of the first upper pixel is positioned to face the first sub-pixel of the second lower pixel, or the second sub-pixel of the first upper pixel is positioned to face the second sub-pixel of the second lower pixel. The third sub-pixel of the first upper pixel is positioned to face the internal region of the third lower pixel.

The display panel may further include at least one of a predetermined material, a sensor, and a fourth sub-pixel. At least one of the predetermined material, sensor, and fourth sub-pixel may be arranged in the internal region. The predetermined material may be configured to allow at least a portion of the incident light to transmit, and the fourth sub-pixel may be configured to emit the fourth light.

In the present embodiment, each of the first upper pixel, first lower pixel, second lower pixel, and third lower pixel may further include the fourth sub-pixel. The fourth sub-pixel may be configured to emit the fourth light and may be disposed in the internal region.

The first upper pixel may further include a second upper pixel and a third upper pixel, and may be positioned to face the first lower pixel. The first upper pixel and the first lower pixel may be arranged within a first pixel group region having a hexagonal shape. The second upper pixel may be positioned to face the second lower pixel. The second upper pixel and the second lower pixel may be arranged within a second pixel group region having a hexagonal shape. The third upper pixel may be positioned to face the third lower pixel. The third upper pixel and the third lower pixel may be arranged within a third pixel group region having a hexagonal shape.

The first upper pixel may be positioned between the first lower pixel and the third lower pixel. The third lower pixel may be positioned between the first upper pixel and the third upper pixel.

An electronic device according to an embodiment of the present disclosure includes a display panel, a processor, a memory, and a power module. The display panel includes a first pixel group, a second pixel group, and a third pixel group, which is adjacent to each other. A plurality of sub-pixel regions that do not overlap each other in a plan view are defined in each of the first, second, and third pixel groups. Among the plurality of sub-pixel regions defined in the first pixel group, light of different wavelengths is emitted from the two closest sub-pixel regions, or no light is emitted from one of the two closest sub-pixel regions. A first sub-pixel region among the plurality of sub-pixel regions defined in the first pixel group is closest to a second sub-pixel region among the plurality of sub-pixel regions defined in the second pixel group. The same light of first light and second light is emitted from each of the first sub-pixel region defined in the first pixel group and the second sub-pixel region defined in the second pixel group. A third sub-pixel region among the plurality of sub-pixel regions defined in the first pixel group is closest to a fourth sub-pixel region among the plurality of sub-pixel regions defined in the third pixel group. The third sub-pixel region is configured to emit third light. No light or fourth light is emitted from the fourth sub-pixel region. The wavelength of the third light is longer than that of the first light and shorter than that of the second light. The fourth light differs from the first, second, and third lights.

An electronic device according to another embodiment of the present disclosure includes a display panel, a processor, a memory, and a power module. The display panel includes a plurality of upper pixels and a plurality of lower pixels. Each of the plurality of upper pixels and each of the plurality of lower pixels includes a first sub-pixel, a second sub-pixel, and a third sub-pixel. The first sub-pixel is configured to emit first light. The second sub-pixel is configured to emit second light. The third sub-pixel is configured to emit third light, which has a wavelength that is longer than that of the first light and shorter than that of the second light. A first distance is defined as the distance between the two closest first sub-pixels among the plurality of first sub-pixels. A second distance is defined as the distance between the two closest second sub-pixels among the plurality of second sub-pixels. A third distance is defined as the distance between the two closest third sub-pixels among the plurality of third sub-pixels. Each of the first and second distances is shorter than the third distance. An internal region is defined between the two closest third sub-pixels. In the internal region, no light is emitted, or fourth light, which differs from the first, second, and third lights, is emitted.

According to an embodiment of the present disclosure, it is possible to provide a technology for addressing the aforementioned issues by arranging sub-pixels that emit red light adjacent to each other and arranging sub-pixels that emit blue light, thereby enlarging the apertures of the mask.

According to another embodiment of the present disclosure, it is possible to provide a technology for preventing a reduction in visibility by arranging sub-pixels that emit red light and blue light adjacent to each other, while not arranging sub-pixels that emit green light adjacent to each other.

At least some of the above and other features of the invention are set out in the claims.

### BRIEF DESCRIPTION OF the DRAWINGS

These and/or other features will become apparent and more readily appreciated from the following description of the embodiments, taken in conjunction with the accompanying drawings in which:
FIG. 1A is an example block diagram of an electronic device according to an embodiment of the present disclosure;
FIG. 1B is an example illustration of electronic devices according to embodiments of the present disclosure;
FIGS. 1C and 1D are example perspective views showing an assembled state and an exploded state, respectively, of an electronic device according to an embodiment of the present disclosure;
FIG. 2A is an example plan view of a display panel according to an embodiment of the present disclosure;
FIG. 2B is an example block diagram of a display panel according to an embodiment of the present disclosure;
FIG. 3 is an example partial cross-sectional view of a display panel according to an embodiment of the present disclosure;
FIGS. 4A to 4D are example illustrations of pixel groups;
FIGS. 5A to 5C are example illustrations of first to third pixel groups according to an embodiment of the present disclosure;
FIGS. 6A to 6D are example illustrations of a plurality of masks for manufacturing the pixel group shown in FIG. 5A;
FIGS. 7A to 11G are example illustrations of pixel groups according to an embodiment of the present disclosure; and
FIG. 12 is an example illustration of two pixel groups shown in FIG. 8A arranged adjacent to each other.

### DETAILED DESCRIPTION

References will now be made in detail to certain embodiments, of which examples are illustrated in the accompanying drawings, where like reference numerals refer to like elements throughout. The embodiments may have a variety of forms and permutations, but the present disclosure shall by no means be construed as being limited to the described embodiments. Rather, the present disclosure shall be construed to encompass all forms, permutations, equivalents and substitutes covered by the technical ideas and scope of the present disclosure. Accordingly, the embodiments are merely described below, by referring to the figures, to explain features of the present disclosure.

Like or identical reference numerals refer to like or identical elements. Moreover, in the accompanying drawings, the thicknesses, ratios, and dimensions of the elements may not be to exact scale and may have been exaggerated for the benefit of effective explanation of the technical features associated with these elements. As such, the present disclosure shall not be restricted to the thicknesses, ratios, dimensions, etc. illustrated in the drawings. The term "and/or" shall include the combination of a plurality of listed items or any of the plurality of listed items that can be defined by relevant elements.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. An expression such as "comprising" or "including" is intended to designate a characteristic, a number, a step, an operation, an element, a part or combinations thereof, and shall not be construed to preclude any possibility of presence or addition of one or more other characteristics, numbers, steps, operations, elements, parts or combinations thereof.

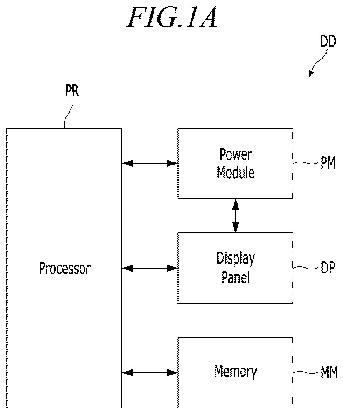

FIG. 1A is an example block diagram of an electronic device DD according to an embodiment of the present disclosure. A display panel DP according to an embodiment of the present disclosure may be applied to various electronic devices DD. The electronic device DD according to an embodiment of the present disclosure includes the aforementioned display panel DP and may further include additional modules or devices with supplementary functions.

Referring to FIG. 1A, the electronic device DD according to an embodiment of the present disclosure may include a display panel DP, a processor PR, a memory MM, and a power module PM. The processor PR may include at least one of a central processing unit (CPU), an application processor (AP), a graphic processing unit (GPU), a communication processor (CP), an image signal processor (ISP), and a controller. Stored in the memory MM may be data and information necessary for the operation of the processor PR or the display panel DP. When the processor PR executes an application stored in the memory MM, at least one of image data signals and input control signals may be transferred to the display panel DP, which may process the received signals to output image information. The power module PM may include a power supply module, such as a power adapter or a battery device, and a power conversion module configured to convert the supplied power to generate the necessary power for the operation of the electronic device DD.

At least one of the aforementioned components of the electronic device DD may be included within the display panel DP according to embodiments of the present disclosure. Moreover, some of the individual modules functionally included in a single module may be partially incorporated within the display panel DP, while others may be provided separately from the display panel DP. For example, the electronic device DD may include the display panel DP, while the processor PR, memory MM, and power module PM may be provided as separate devices within the electronic device DD, independent of the display panel DP.

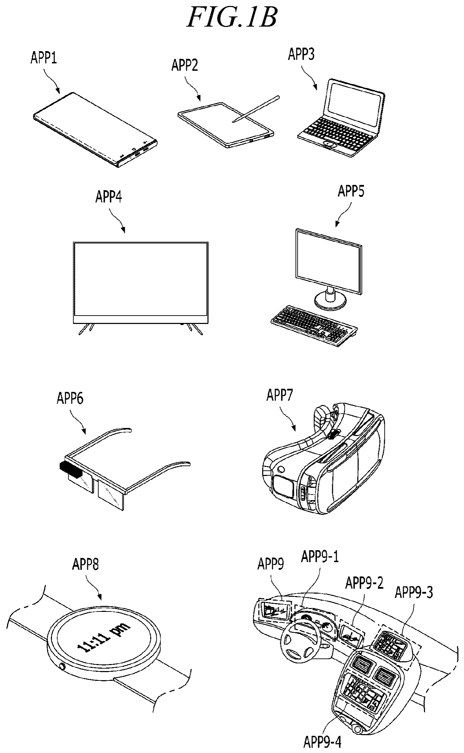

FIG. 1B is an example illustration of electronic devices DD according to embodiments of the present disclosure. Referring to FIG. 1B, various electronic devices DD to which the display panel DP according to embodiments of the present disclosure is applied may include not only image displaying electronic devices, such as a smartphone APP1, a tablet PC APP2, a laptop computer APP3, a TV APP4, and a desktop monitor APPS, but also wearable electronic devices including the display panel DP, such as smart glasses APP6, a head-mounted display APP7, and a smartwatch APP8. Additionally, the electronic device DD may include vehicle electronic devices APP9 - APP9-4 such as a center information display (CID) arranged in the instrument cluster, center fascia, or dashboard of a vehicle, or a room mirror display.

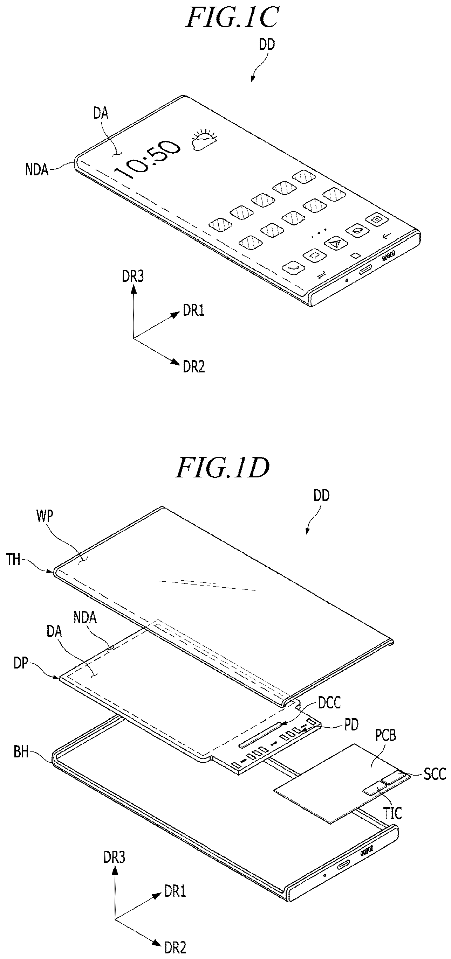

Hereinafter, the electronic device DD will be described based on the example where the electronic device DD is the smartphone APP1 shown in FIG. 1B. FIGS. 1C and 1D are example perspective views showing an assembled state and an exploded state, respectively, of an electronic device DD according to an embodiment of the present disclosure.

In embodiments of the present disclosure, a first direction DR1, a second direction DR2, and a third direction DR3 may be defined. The first direction DR1, the second direction DR2, and the third direction DR3 may be directions that intersect each other. When viewed along the third direction DR3, the electronic device DD is illustrated as having a rectangular shape extending in the first direction DR1 and the second direction DR2. However, the shape of the electronic device DD is not limited thereto.

Referring to FIGS. 1C and 1D, the electronic device DD may include a display area DA and a non-display area NDA. The display area DA may be an area where images are displayed. The non-display area NDA may be an area where images are not displayed and may surround the display area DA. It should be noted however that the shapes of the display area DA and the non-display area NDA shown in FIGS. 1C and 1D are merely examples and may be modified without limitation as needed.

Referring to FIGS. 1C and 1D, the electronic device DD may include an upper housing TH, a lower housing BH, and the display panel DP. The upper housing TH may include a window member WP and may be disposed above the display panel DP.

The window member WP may be configured to allow incident light to pass through. Specifically, an image displayed on the display panel DP may be visible to the user through the window member WP. The window member WP may overlap the display area DA. The window member WP may include a transparent material and allow light to transmit. The window member WP may include an insulating material, such as glass, plastic, or a combination thereof.

The lower housing BH may be disposed below the display panel DP and may be configured to protect the display panel DP from external impacts. The lower housing BH may accommodate the display panel DP.

The display panel DP may be included in the electronic device DD shown in FIGS. 1C and 1D. The display panel DP may have the display area DA and the non-display area NDA, which overlap, respectively, the display area DA and non-display area NDA of the electronic device DD, defined therein.

In an embodiment of the present disclosure, the display panel DP may be a light-emitting display panel. For example, the display panel DP may be any one of an organic light-emitting display panel, a quantum dot light-emitting display panel, a micro LED display panel, a liquid crystal display panel, an electrophoretic display panel, an electrowetting display panel. A light-emitting layer of the organic light-emitting display panel may include organic light-emitting materials. The inorganic light-emitting display panel may include inorganic-based materials such as a quantum dot light-emitting display panel and a micro light-emitting display panel. Hereinafter, the display panel DP will be described based on the example of an organic light-emitting display panel.

Although a smartphone is illustrated as the electronic device DD in FIGS. 1C and 1D, the electronic device DD of the present disclosure is not limited thereto. In other embodiments, the electronic device DD may include large-sized and medium-to-small-sized display devices. For example, the large-sized display devices may include televisions, monitors, and electronic billboards, while the medium-to-small-sized display devices may include tablets, built-in home appliance displays, smartwatches, and smartphones.

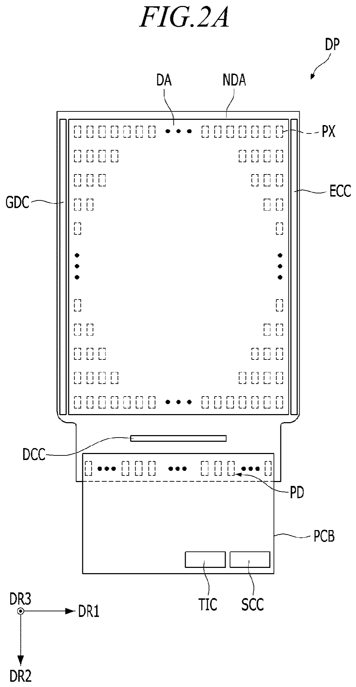

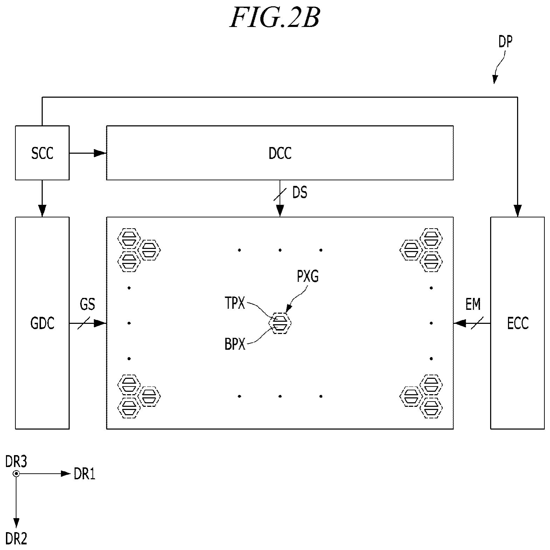

FIG. 2A is an example plan view of a display panel DP according to an embodiment of the present disclosure. As used herein, the "plan view" is a view in a thickness direction (i.e., third direction DR3) of the display panel DP. FIG. 2B is an example block diagram of a display panel DP according to an embodiment of the present disclosure. Referring to FIGS. 2A and 2B, the display panel DP may include a gate driving circuit GDC, a light-emission control circuit ECC, a data driving circuit DDC, a printed circuit board PCB, an input sensing driving circuit TIC, a signal control circuit SCC, a plurality of pads PD, and pixels PX.

The gate driving circuit GDC may be configured to receive control signals from the signal control circuit SCC and provide gate signals GS to the pixels PX. In an embodiment of the present disclosure, the gate driving circuit GDC may be formed simultaneously with the pixels PX through a thin-film process. For example, the gate driving circuit GDC may be installed in the form of an oxide semiconductor TFT gate driver circuit (OSG) or an amorphous silicon TFT gate driver circuit (ASG).

The light-emission control circuit ECC may be configured to receive control signals from the signal control circuit SCC and to provide light-emission control signals EM to the pixels PX. The light-emission control signal EM may be an electrical signal configured for controlling light emission.

The data driving circuit DDC may be configured to receive control signals from the signal control circuit SCC and to provide data signals DS to the pixels PX.

The input sensing driving circuit TIC and the signal control circuit SCC may be mounted on the printed circuit board PCB and may be configured to receive electrical signals from the plurality of pads PD. The input sensing driving circuit TIC may be configured to process signals corresponding to the user's touch and signals corresponding to externally applied pressure.

The signal control circuit SCC, for example, a timing controller, may be configured to control at least one of the input sensing driving circuit TIC, the gate driving circuit GDC, the data driving circuit DDC, and the light-emission control circuit ECC. The signal control circuit SCC may be configured to receive image data and control signals from an external graphic controller (not shown). The control signals may include a vertical synchronization signal, a horizontal synchronization signal, a data enable signal, and a clock signal. The vertical synchronization signal may be a signal configured to distinguish frame intervals, and the horizontal synchronization signal may be a signal configured to distinguish horizontal intervals (i.e., a row distinction signal).

In FIG. 2A, the gate driving circuit GDC and the light-emission control circuit ECC are illustrated as separate components arranged apart from each other. However, the gate driving circuit GDC and the light-emission control circuit ECC of the present disclosure are not limited thereto and may be configured as a single component in other embodiments.

The pixels PX may be provided in plurality. A pixel group PXG may include at least some of the plurality of pixels PX. Among the pixels PX included in the pixel group PXG, one may be an upper pixel TPX, and another one may be a lower pixel BPX. In an embodiment of the present disclosure, the pixel groups PXG may be provided in plurality.

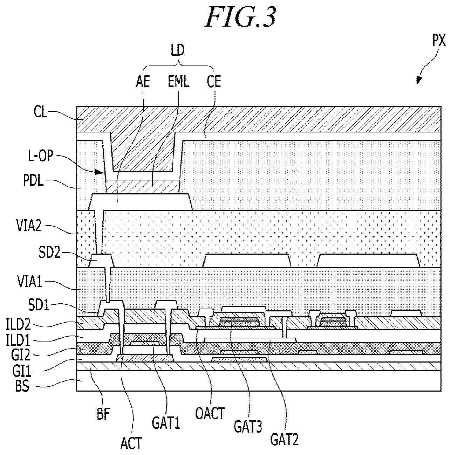

FIG. 3 is an example partial cross-sectional view of a display panel DP according to an embodiment of the present disclosure. Referring to FIG. 3, the display panel DP according to an embodiment of the present disclosure may include a base substrate BS, a buffer layer BF, a semiconductor pattern ACT, OACT, a gate insulation layer GI1, GI2, a gate pattern GAT1, GAT2, an interlayer-insulation layer ILD1, ILD2, a conductive pattern SD1, SD2, a Via-Layer VIA1, VIA2, a pixel defining layer PDL, and an encapsulation layer CL.

The semiconductor pattern ACT, OACT may include at least one of a lower semiconductor pattern ACT and an upper semiconductor pattern OACT. The lower semiconductor pattern ACT and the upper semiconductor pattern OACT may be arranged on different layers.

The gate insulation layer GI1, GI2 may include a first gate insulation layer GI1 and a second gate insulation layer GI2.

The gate pattern GAT1, GAT2 may include at least one of a sub-gate pattern GAT1, a lower gate pattern GAT2, and an upper gate pattern GAT3. The sub-gate pattern GAT1, lower gate pattern GAT2, and upper gate pattern GAT3 may be arranged on different layers.

The interlayer-insulation layer ILD1, ILD2 may include a first interlayer-insulation layer ILD1 and a second interlayer-insulation layer ILD2.

The conductive pattern SD1, SD2 may include at least one of a lower conductive pattern SD1 and an upper conductive pattern SD2.

The Via-Layer VIA1, VIA2 may include a first Via-Layer VIA1 and a second Via-Layer VIA2.

The buffer layer BF may be disposed between the base substrate BS and the lower semiconductor pattern ACT. The buffer layer BF may include at least one of inorganic and organic materials. For example, the buffer layer BF may include at least one of silicon nitride, silicon oxynitride, silicon oxide, titanium oxide, aluminum oxide, and acrylic-based organic materials.

The lower semiconductor pattern ACT may be disposed on the buffer layer BF and may include semiconductor materials. In an embodiment of the present disclosure, the semiconductor material may include at least one of amorphous silicon semiconductor, polycrystalline silicon semiconductor, metal oxide semiconductor, crystalline oxide semiconductor, and amorphous oxide semiconductor. For example, the oxide semiconductor may include at least one of indium-tin oxide (ITO), indium-gallium-zinc oxide (IGZO), zinc oxide (ZnO), indium-zinc oxide (IZnO), zinc-indium oxide (ZIO), indium oxide (InO), titanium oxide (TiO), indium-zinc-tin oxide (IZTO), and zinc-tin oxide (ZTO).

The first gate insulation layer GI1 may be disposed on the buffer layer BF and may cover the lower semiconductor pattern ACT. The first gate insulation layer GI1 may include at least one of organic and inorganic insulating materials. For example, the first gate insulation layer GI1 may include at least one of polysiloxane, silicon nitride, silicon oxide, silicon oxynitride, polyacrylic compounds, polyimide compounds, fluorocarbon compounds, and benzocyclobutene compounds. The first gate insulation layer GI1 may further include at least one additional layer containing an insulating material.

The sub-gate pattern GAT1 may be disposed on the first gate insulation layer GI1. At least a portion of the sub-gate pattern GAT1 may overlap the lower semiconductor pattern ACT in a plan view. The sub-gate pattern GAT1 may include metal materials. For example, the sub-gate pattern GAT1 may include at least one of gold (Au), silver (Ag), aluminum (Al), molybdenum (Mo), chromium (Cr), titanium (Ti), nickel (Ni), neodymium (Nd), and copper (Cu).

The second gate insulation layer GI2 may be disposed on the first gate insulation layer GI1 and may cover at least one of the sub-gate pattern GAT1 and the upper semiconductor pattern OACT. The second gate insulation layer GI2 may include at least one of organic and inorganic insulating materials. For example, the second gate insulation layer GI2 may include at least one of polysiloxane, silicon nitride, silicon oxide, silicon oxynitride, polyacrylic compounds, polyimide compounds, fluorocarbon compounds, and benzocyclobutene compounds. and may further include additional insulating layers. The second gate insulation layer GI2 may further include at least one additional layer containing an insulating material.

The lower gate pattern GAT2 may be disposed on the second gate insulation layer GI2. The lower gate pattern GAT2 may include metals. For example, the lower gate pattern GAT2 may include at least one of gold (Au), silver (Ag), aluminum (Al), molybdenum (Mo), chromium (Cr), titanium (Ti), nickel (Ni), neodymium (Nd), and copper (Cu).

The first interlayer-insulation layer ILD1 may be disposed on the second gate insulation layer GI2. The second gate insulation layer GI2 may cover the lower gate pattern GAT2. The first interlayer-insulation layer ILD1 may include insulating materials. For example, first interlayer-insulation layer ILD1 may include at least one of polysiloxane, silicon nitride, silicon oxide, and silicon oxynitride.

The upper gate pattern GAT3 may be disposed on the second gate insulation layer GI2. The upper gate pattern GAT3 may include metals. For example, the upper gate pattern GAT3 may include at least one of gold (Au), silver (Ag), aluminum (Al), molybdenum (Mo), chromium (Cr), titanium (Ti), nickel (Ni), neodymium (Nd), and copper (Cu).

The second interlayer-insulation layer ILD2 may be disposed on the first interlayer-insulation layer ILD1. The second interlayer-insulation layer ILD2 may cover the upper gate pattern GAT3. The second interlayer-insulation layer ILD2 may include insulating materials. For example, the second interlayer-insulation layer ILD2 may include at least one of polysiloxane, silicon nitride, silicon oxide, and silicon oxynitride.

The lower conductive pattern SD1 may be disposed on the second interlayer-insulation layer ILD2. The lower conductive pattern SD1 may be electrically connected to at least one of the lower semiconductor pattern ACT, the lower gate pattern GAT2, and the upper semiconductor pattern OACT. The lower conductive pattern SD1 may include metals. For example, the lower conductive pattern SD1 may include at least one of gold (Au), silver (Ag), aluminum (Al), molybdenum (Mo), chromium (Cr), titanium (Ti), nickel (Ni), neodymium (Nd), and copper (Cu).

The first Via-Layer VIA1 may be disposed on the second interlayer-insulation layer ILD2 and may cover the lower conductive pattern SD1. The upper conductive pattern SD2 may penetrate the first Via-Layer VIA1 to make contact with at least a portion of the lower conductive pattern SD1.

The second Via-Layer VIA2 may be disposed on the first Via-Layer VIA1 and may cover the upper conductive pattern SD2. The pixel defining layer PDL may be disposed on the second Via-Layer VIA2. The pixel defining layer PDL may have a light-emitting diode opening L-OP defined therein, and a light-emitting diode LD may be disposed within the light-emitting diode opening L-OP.

The light-emitting diode LD may be disposed above the first and second Via-Layers VIA1, VIA2. The light-emitting diode LD may include an anode electrode AE, a light-emitting layer EML, and a cathode electrode CE. The anode electrode AE may be electrically connected to at least one of the lower semiconductor pattern ACT, the lower gate pattern GAT2, and the upper semiconductor pattern OACT through the lower and upper conductive patterns SD1 and SD2.

The encapsulation layer CL may cover the light-emitting diode LD to protect the light-emitting diode LD from oxygen and moisture. For example, the encapsulation layer CL may include at least one of silicon oxide, silicon nitride, and silicon oxynitride. The encapsulation layer CL may include at least one of organic and inorganic materials. In another embodiment of the present disclosure, the encapsulation layer CL may further include at least one additional layer including at least one of organic and inorganic materials.

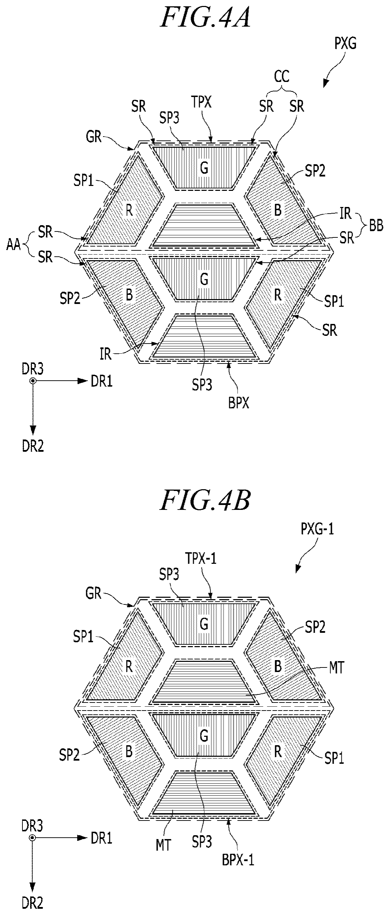

FIGS. 4A to 4D are example illustrations of pixel groups PXG, PXG-1, PXG-2, PXG-3 according to an embodiment of the present disclosure. Referring to FIG. 4A, each of the plurality of pixel groups PXG may include an upper pixel TPX and a lower pixel BPX facing each other. The upper pixel TPX and the lower pixel BPX may each be provided in plurality.

In an embodiment of the present disclosure, a plurality of sub-pixel regions SR that do not overlap each other in a plan view may be defined in each of the plurality of pixel groups PXG. At least one of the plurality of sub-pixel regions SR in each of the plurality of pixel groups PXG may be an internal region IR.

In another embodiment of the present disclosure, a plurality of sub-pixel regions SR may be defined in each of the plurality of upper pixels TPX and plurality of lower pixels BPX. At least one of the plurality of sub-pixel regions SR in each of the plurality of upper pixels TPX may be an internal region IR, and at least one of the plurality of sub-pixel regions SR in each of the plurality of lower pixels BPX may be an internal region IR.

In an embodiment of the present disclosure, light of different wavelengths may be emitted from sub-pixel regions in the two closest sub-pixel regions (e.g., AA, BB, CC), or no light may be emitted from one (e.g., internal region IR) of the two closest sub-pixel regions, among the plurality of sub-pixel regions SR defined in each of the plurality of pixel groups PXG.

In the present specification, the distance between sub-pixel regions refers to the distance from the center of one sub-pixel region to the center of another sub-pixel region, or the distance from a far edge of one sub-pixel region to a far edge of another sub-pixel region. The center of a sub-pixel region may be defined as the geometric center, centroid, incenter, or circumcenter.

In the present specification, the term "the two closest sub-pixel regions" refers to any two sub-pixel regions having the shortest distance between the two sub-pixel regions, with no other sub-pixel region in between the aforementioned two sub-pixel regions.

The upper pixel TPX and the lower pixel BPX may each include first to third sub-pixels SP1 - SP3. The first sub-pixel SP1 may be configured to emit first light. The second sub-pixel SP2 may be configured to emit second light. The third sub-pixel SP3 may be configured to emit third light, which may have a wavelength longer than a wavelength of the second light and shorter than a wavelength of the first light.

Referring to FIG. 4A, the first sub-pixel SP1 of the upper pixel TPX may be positioned to face the second sub-pixel SP2 of the lower pixel BPX, and the second sub-pixel SP2 of the upper pixel TPX may be positioned to face the first sub-pixel SP1 of the lower pixel BPX. The internal region IR defined in the upper pixel TPX may be positioned to face the third sub-pixel SP3 of the lower pixel BPX.

In an embodiment of the present disclosure, no light or fourth light may be emitted from the internal region IR.

In an embodiment of the present disclosure, the first light may be a color having a wavelength within a first range, the second light may be a color having a wavelength within a second range, and the third light may be a color having a wavelength within a third range. The first range may be from 625 nanometers (nm) to 750 nm, the second range from 450 nm to 500 nm, and the third range from 520 nm to 570 nm. In another embodiment of the present disclosure, the first light may be red light, the second light blue light, the third light green light, and the fourth light white light.

Referring to FIGS. 4B to 4D, pixel groups PXG-1, PXG-2, PXG-3 according to an embodiment of the present disclosure may further include at least one of a predetermined material MT, a sensor SS, and a fourth sub-pixel SP4.

Referring to FIG. 4B, each of the upper pixel TPX-1 and lower pixel BPX-1 of the pixel group PXG-1 may further include a predetermined material MT. The predetermined material MT may be configured to transmit at least a portion of incident light and may be disposed in the internal region IR.

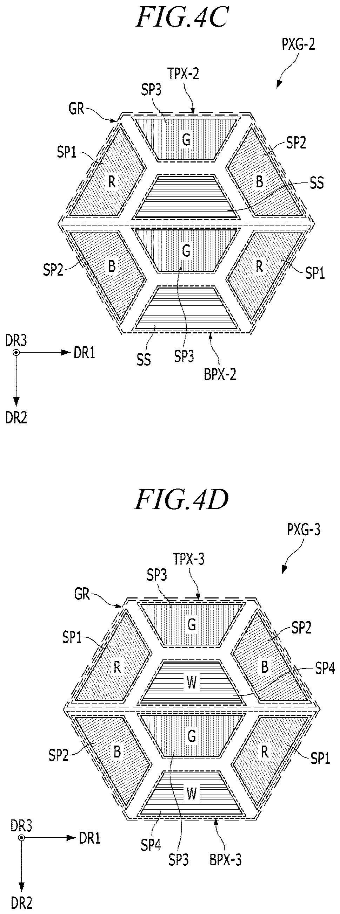

Referring to FIG. 4C, each of the upper pixel TPX-2 and lower pixel BPX-2 of the pixel group PXG-2 may further include a sensor SS, which may be disposed in the internal region IR. The sensor SS may be configured to sense at least one of, for example, touch, pressure, light, and heat. In another embodiment of the present disclosure, the sensor SS may be an optical sensor, which may include, for example, a charge-coupled device (CCD) sensor, a complementary metal-oxide-semiconductor (CMOS) sensor, a photodiode, a phototransistor, a quantum dot sensor, an infrared sensor, a LiDAR sensor, and an inductive sensor.

Referring to FIG. 4D, each of the upper pixel TPX-3 and lower pixel BPX-3 of the pixel group PXG-3 may further include a fourth sub-pixel SP4, which may be configured to emit the fourth light. The fourth sub-pixel SP4 may be disposed in the internal region IR. The fourth light may differ from the first, second, and third lights. For example, the fourth light may be white light.

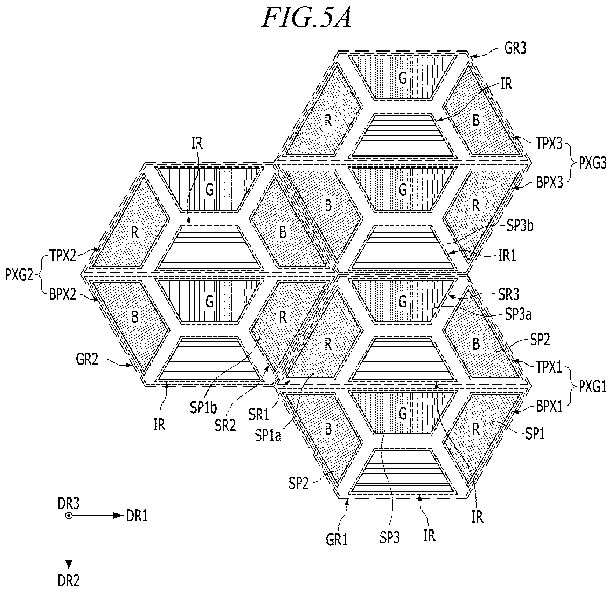

FIGS. 5A to 5C are example illustrations of first to third pixel groups PXG1 - PXG3 according to an embodiment of the present disclosure.

The display panel DP may include a plurality of upper pixels TPX and a plurality of lower pixels BPX. The plurality of upper pixels TPX and the plurality of lower pixels BPX may each include first to third sub-pixels SP1 - SP3. The first to third sub-pixels SP1 - SP3 may be configured to emit first to third lights, respectively.

Referring to FIG. 5A, in an embodiment of the present disclosure, at least one lower pixel BPX may be arranged between any two upper pixels of the plurality of upper pixels TPX. A third lower pixel BPX3 may be disposed between a first upper pixel TPX1 and a third upper pixel TPX3. In another embodiment of the present disclosure, the plurality of upper pixels TPX and the plurality of lower pixels BPX may be alternately arranged along the first direction DR1 and the second direction DR2.

The display panel DP according to an embodiment of the present disclosure may include first to third pixel groups PXG1 - PXG3. The first to third pixel groups PXG1 - PXG3 may be adjacent to each other. The first pixel group PXG1 may include a first upper pixel TPX1 and a first lower pixel BPX1 facing each other. The first pixel group PXG1 may be arranged within a first pixel group region GR1, which has a hexagonal shape. The second pixel group PXG2 may include a second upper pixel TPX2 and a second lower pixel BPX2 facing each other. The second pixel group PXG2 may be arranged within a second pixel group region GR2, which has a hexagonal shape. The third pixel group PXG3 may include a third upper pixel TPX3 and a third lower pixel BPX3 facing each other. The third pixel group PXG3 may be arranged within a third pixel group region GR3, which has a hexagonal shape.

In an embodiment of the present disclosure, the first upper pixel TPX1 may be positioned between the first lower pixel BPX1 and the third lower pixel BPX3, and the third lower pixel BPX3 may be positioned between the first upper pixel TPX1 and the third upper pixel TPX3.

In an embodiment of the present disclosure, two sub-pixel regions, defined in different pixel groups and each being configured to emit first light, may be arranged adjacent to each other. Moreover, two sub-pixel regions, defined in different pixel groups and each being configured to emit second light, may be arranged adjacent to each other. On the contrary, two sub-pixel regions, defined in different pixel groups and each being configured to emit third light, may not be arranged adjacent to each other.

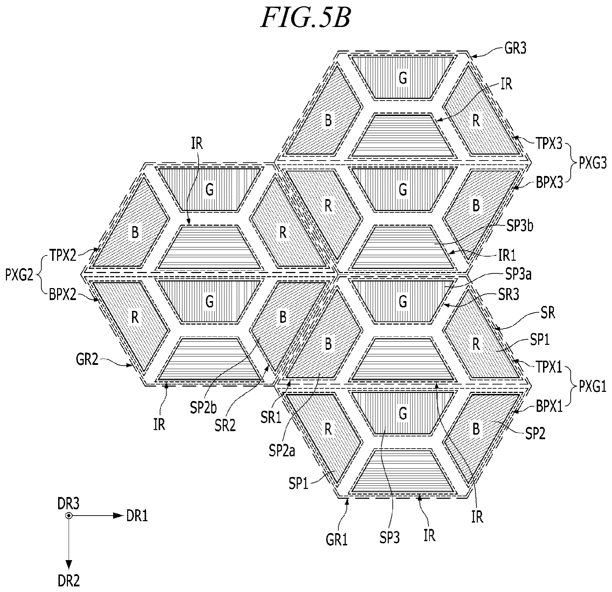

In FIGS. 5A and 5B, a first sub-pixel region SR1 and a second sub-pixel region SR2 defined in different pixel groups PXG1, PXG2, respectively, and may be positioned closest to each other. For example, the first sub-pixel region SR1 in a first upper pixel TPX1 of the first pixel groups PXG1 and the second sub-pixel region SR2 in a second lower pixel BPX2 of the second pixel groups PXG2 may be positioned closest to each other. In an embodiment, among the plurality of sub-pixel regions SR, third sub-pixel regions SR3 in the first pixel group PXG1 and a first internal region IR1 in the third pixel group PXG3 may be positioned closest to each other.

Referring to FIG. 5A, the first light (e.g., red light R) may be emitted from both the first pixel region SR1 and the second sub-pixel region SR2 of different pixels. For example, the first sub-pixel SPla of the first upper pixel TPX1 may be disposed in the first sub-pixel region SR1, and the first sub-pixel SP1b of the second lower pixel BPX2 may be disposed in the second sub-pixel region SR2. Therefore, the first sub-pixel SPla of the first upper pixel TPX1 may be positioned to face the first sub-pixel SP1b of the second lower pixel BPX2.

Referring to FIG. 5B, the second light (e.g., blue light B) may be emitted from both the first sub-pixel region SR1 and the second sub-pixel region SR2 of different pixels. For example, the second sub-pixel SP2a of the first upper pixel TPX1 may be disposed in the first sub-pixel region SR1, and the second sub-pixel SP2b of the second lower pixel BPX2 may be disposed in the second sub-pixel region SR2. Therefore, the second sub-pixel SP2a of the first upper pixel TPX1 may be positioned to face the second sub-pixel SP2b of the second lower pixel BPX2.

Referring to FIGS. 5A and 5B, the third light (e.g., green light G) may be emitted from the third sub-pixel regions SR3, while no light or the fourth light (e.g., white light W) may be emitted from the first internal region IR1. For example, the third sub-pixel SP3a of the first upper pixel TPX1 may be disposed in the third sub-pixel region SR3. The third sub-pixel SP3a of the first upper pixel TPX1 may be positioned to face the first internal region IR1 of the third lower pixel BPX3.

In an embodiment of the present disclosure, the two first sub-pixels SP1a, SP1b, belonging to different pixel groups and configured to emit the first light, may be arranged adjacent to each other. Moreover, the two second sub-pixels SP2a, SP2b, belonging to different pixel groups and configured to emit the second light, may be arranged adjacent to each other. On the contrary, the two third sub-pixels, belonging to different pixel groups and configured to emit the third light, may not be arranged adjacent to each other.

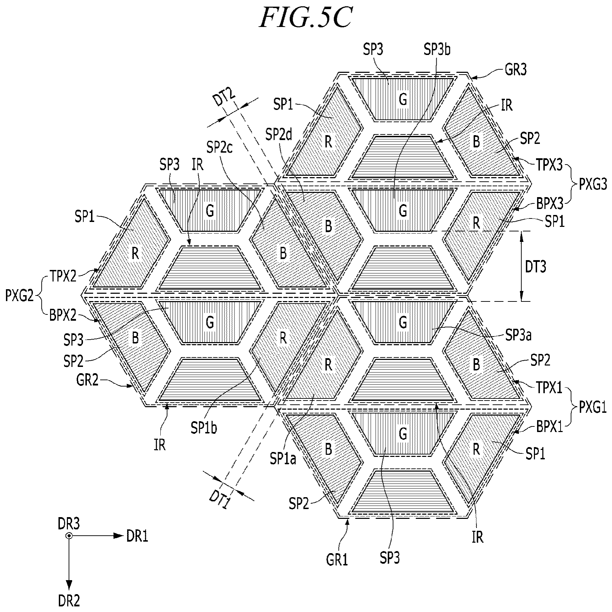

Referring to FIG. 5C, the distance between the two closest first sub-pixels SP1a, SP1b may be defined as a first distance DT1. The distance between the two closest second sub-pixels SP2c, SP2d may be defined as a second distance DT2. The distance between the two closest third sub-pixels SP3a, SP3b may be defined as a third distance DT3. The internal region IR may be defined between the two closest third sub-pixels SP3a, SP3b. In an embodiment of the present disclosure, the first distance DT1 and the second distance DT2 may each be shorter than the third distance DT3.

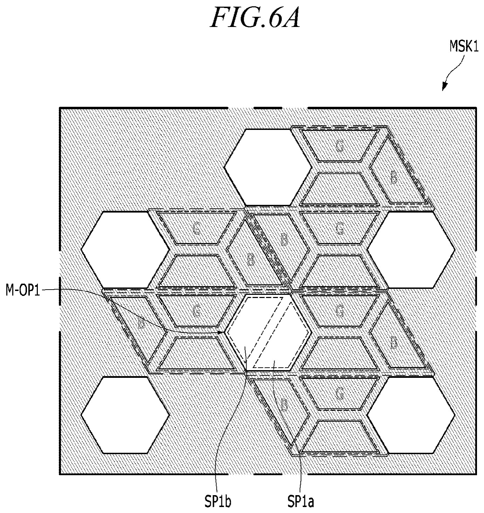

FIGS. 6A to 6D are example illustrations of a plurality of masks MSK1, MSK2, MSK3, MSK4 for manufacturing the pixel group PXG shown in FIG. 5A. For example, each of the plurality of masks MSK1, MSK2, MSK3, MSK4 may be a fine metal mask ("FMM").

Referring to FIGS. 5A and 6A, the first mask MSK1 may be a mask for fabricating the plurality of first sub-pixels SP1. The first mask MSK1 may have a plurality of first mask openings M-OP1 defined therein. A material for forming the first sub-pixels SP1 may pass through the plurality of first mask openings M-OP1 and then be deposited over the base substrate BS.

If a sub-pixel emitting a light other than the first light is positioned between the two first sub-pixels SP1a, SP1b emitting the first light, the materials for manufacturing the two first sub-pixels SP1a, SP1b must be deposited separately through different first mask openings M-OP1. On the contrary, since no sub-pixel emitting a light other than the first light is positioned between the two first sub-pixels SP1a, SP1b in the present disclosure, it is possible to deposit the materials for fabricating the two first sub-pixels SP1a, SP1b simultaneously through the single first mask opening M-OP1.

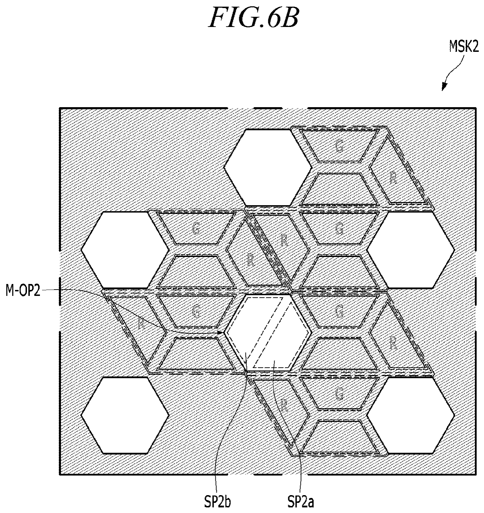

Referring to FIGS. 5B and 6B, the second mask MSK2 may be a mask for fabricating the plurality of second sub-pixels SP2. The second mask MSK2 may have a plurality of second mask openings M-OP2 defined therein. A material for forming the second sub-pixels SP2 may pass through the plurality of second mask openings M-OP2 and then be deposited over the base substrate BS.

If a sub-pixel emitting a different light than the second light is positioned between two second sub-pixels SP2a, SP2b emitting the second light, the materials for manufacturing the two second sub-pixels SP2a, SP2b must be deposited separately through different second mask openings M-OP2. However, in the present disclosure, since no sub-pixel emitting different light than the second light is positioned between the two second sub-pixels SP2a, SP2b, it is possible to deposit the materials for fabricating the two second sub-pixels SP2a, SP2b simultaneously through the single second mask opening M-OP2.

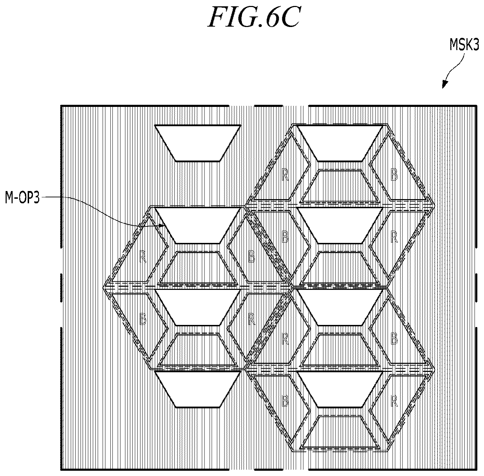

Referring to FIGS. 5A and 6C, the third mask MSK3 may be a mask for fabricating the plurality of third sub-pixels SP3. The third mask MSK3 may have a plurality of third mask openings M-OP3 defined therein. A material for forming the third sub-pixels SP3 may pass through the plurality of third mask openings M-OP3 and then be deposited over the base substrate BS.

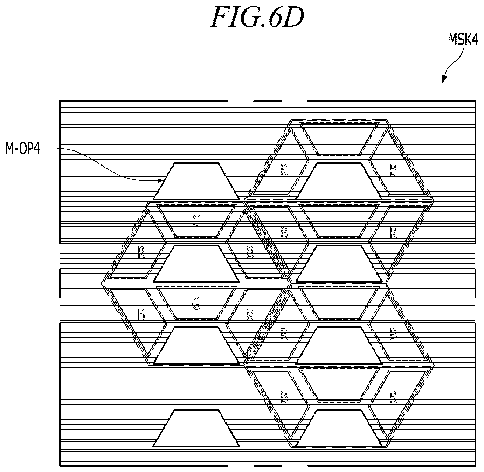

Referring to FIGS. 5A and 6D, the fourth mask MSK4 may have a plurality of fourth mask openings M-OP4 defined therein. At least one of a material for forming a sensor SS (shown in FIG. 4C), a material for forming a fourth sub-pixel SP4 (shown in FIG. 4D), and a predetermined material MT (shown in FIG. 4B) may pass through the plurality of fourth mask openings M-OP4 and then be deposited over the base substrate BS.

By using the present disclosure, masks MSK1, MSK2, MSK3, MSK4 with larger mask openings M-OP1, M-OP2, M-OP3, M-OP4 may be utilized in the deposition process for manufacturing the sub-pixels SP. The larger the mask openings M-OP1, M-OP2, M-OP3, M-OP4, the easier and less expensive it becomes to manufacture the masks MSK1, MSK2, MSK3, MSK4. The shapes of the first to fourth masks MSK1, MSK2, MSK3, MSK4 shown in FIGS. 6A to 6D are examples, and the shapes of the first to fourth masks MSK1, MSK2, MSK3, MSK4 in the present disclosure is not limited thereto.

Referring to FIGS. 4A to 5C, in an embodiment of the present disclosure, the shapes of the first sub-pixel SP1, the second sub-pixel SP2, the third sub-pixel SP3, the fourth sub-pixel SP4, and the internal region IR may be closed shapes.

In the present specification, the shape of a sub-pixel refers to the shape of the sub-pixel observed at a position spaced apart in the third direction DR3 or the opposite of the third direction DR3 from the display panel DP (i.e., plan view). The shape of each of the first sub-pixel SP1, the second sub-pixel SP2, the third sub-pixel SP3, and the fourth sub-pixel SP4 may be at least one of the shapes of the anode electrode AE, the light-emitting layer EML, and the cathode electrode CE.

FIGS. 4A to 6D illustrate a case that each of the sub-pixel and sub-pixel region has an Isosceles trapezoid shape. However, the shape of each of the sub-pixel and sub-pixel region is not limited thereto.

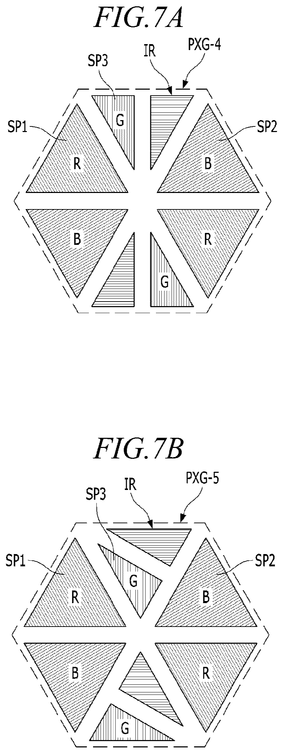

Hereinafter, the shapes of the first sub-pixel SP1, the second sub-pixel SP2, the third sub-pixel SP3, the fourth sub-pixel SP4, and the internal region IR will be described with reference to FIGS. 7A to 11J. FIGS. 7A to 11J are example illustrations of pixel groups PXG-4 - PXG-21 according to an embodiment of the present disclosure.

Referring to FIGS. 7A and 7B, in pixel groups PXG-4, PXG-5 according to an embodiment of the present disclosure, the shape of each of the first to third sub-pixels SP1 - SP3 may be triangular, and the shape of the internal region IR may also be triangular. A fourth sub-pixel SP4 having a triangular shape may be disposed within the internal region IR.

In an embodiment of the present disclosure, the longest line segment among the line segments defined in the internal region IR may be positioned to face any one of the first sub-pixel SP1 and the second sub-pixel SP2, and the longest line segment among the line segments defined in the third sub-pixel SP3 may be positioned to face another one of the first sub-pixel SP1 and the second sub-pixel SP2.

In another embodiment of the present disclosure, the longest line segment among the line segments defined in one of the third sub-pixels SP3 may be positioned to face one of the first sub-pixel SP1 and the second sub-pixel SP2, while the longest line segment among the line segments defined in another one of the third sub-pixels SP3 may not be positioned to face either the first sub-pixel SP1 or the second sub-pixel SP2.

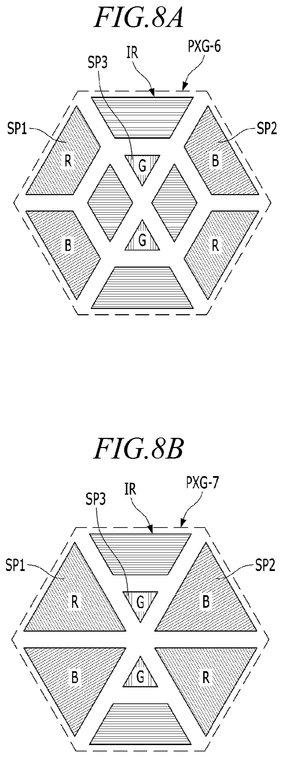

Referring to FIG. 8A, in a pixel group PXG-6 according to an embodiment of the present disclosure, the first sub-pixel SP1 and the second sub-pixel SP2 may each have a trapezoidal shape (e.g., isosceles trapezoidal shape), while the third sub-pixel SP3 may have a triangular shape, and the internal region IR may have a rectangular shape. In another embodiment of the present disclosure, a fourth sub-pixel (not shown) having a rectangular shape may be disposed within the internal region IR.

In an embodiment of the present disclosure, the number of third sub-pixels SP3 may differ from the number of internal regions IR. For example, the number (e.g., two) of third sub-pixels SP3 may be smaller than the number (e.g., four) of internal regions IR. In an embodiment of the present disclosure, the third sub-pixel SP3 may be disposed in between any three internal regions.

Referring to FIG. 8B, in a pixel group PXG-7 according to an embodiment of the present disclosure, the first sub-pixel SP1, the second sub-pixel SP2, and the third sub-pixel SP3 may each have a triangular shape, while the internal region IR may have a trapezoidal shape (e.g., isosceles trapezoidal shape). In another embodiment of the present disclosure, a fourth sub-pixel (not shown) having a trapezoidal shape (e.g., isosceles trapezoidal shape) may be disposed within the internal region IR.

In an embodiment of the present disclosure, the area of at least one of the third sub-pixels SP3 may differ from the area of at least one of the internal regions IR. For example, the area of each of the third sub-pixels SP3 may be smaller than the area of each of the internal regions IR.

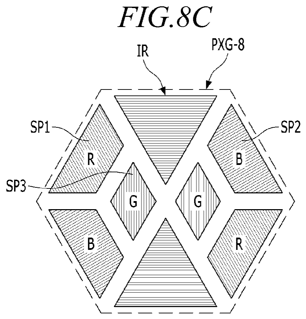

Referring to FIG. 8C, in a pixel group PXG-8 according to an embodiment of the present disclosure, the first and second sub-pixels SP1 and SP2 may have a trapezoidal shape (e.g., isosceles trapezoidal shape) and the third sub-pixel SP3 may have a rhombus shape, while the internal region IR may have a triangular shape. In another embodiment of the present disclosure, a fourth sub-pixel (not shown) having a triangular shape may be disposed within the internal region IR.

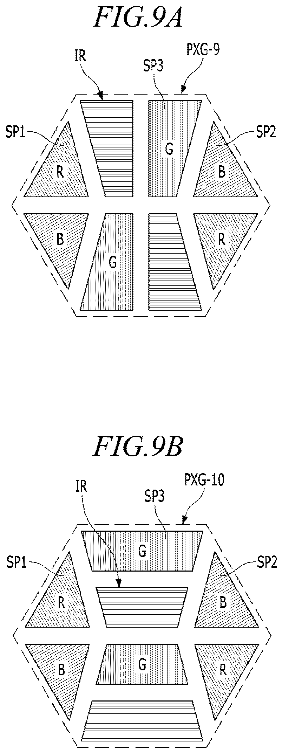

Referring to FIG. 9A, in a pixel group PXG-9 according to an embodiment of the present disclosure, the first sub-pixel SP1 and the second sub-pixel SP2 may each have a triangular shape, while the third sub-pixel SP3 and the internal region IR may each have a trapezoidal shape. In another embodiment of the present disclosure, a fourth sub-pixel (not shown) having a trapezoidal shape may be disposed within the internal region IR.

In an embodiment of the present disclosure, the area of the third sub-pixel SP3 may be equal to the area of the internal region IR. In an embodiment, the shape of the third sub-pixel SP3 may be a mirror image of the shape of the internal region IR.

Referring to FIG. 9B, in a pixel group PXG-10 according to an embodiment of the present disclosure, the first sub-pixel SP1 and the second sub-pixel SP2 may each have a triangular shape, while the third sub-pixel SP3 and the internal region IR may each have a trapezoidal shape (e.g., isosceles trapezoidal shape). In another embodiment of the present disclosure, a fourth sub-pixel (not shown) having a trapezoidal shape (e.g., isosceles trapezoidal shape) may be disposed within the internal region IR.

In an embodiment of the present disclosure, the longest side of the third sub-pixel SP3 and the longest side of the internal region IR may not face the first sub-pixel SP1 or the second sub-pixel SP2.

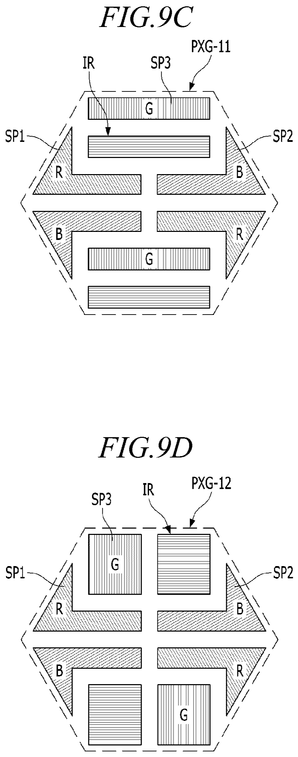

Referring to FIGS. 9C and 9D, in pixel groups PXG-11, PXG-12 according to an embodiment of the present disclosure, the first sub-pixel SP1 and the second sub-pixel SP2 may each have a pentagonal shape (e.g., arrow shape), while the third sub-pixel SP3 and the internal region IR may each have a rectangular or square shape. In another embodiment of the present disclosure, a fourth sub-pixel (not shown) having a rectangular shape may be disposed within the internal region IR.

In an embodiment of the present disclosure, the shape of the first sub-pixel SP1 may be a mirror image of the shape of the second sub-pixel SP2, and the shape of the third sub-pixel SP3 may be the same as the shape of the internal region IR.

In an embodiment of the present disclosure, the longest side of the third sub-pixel SP3 and the longest side of the internal region IR in FIG. 9C may not face the first sub-pixel SP1 or the second sub-pixel SP2.

In an embodiment of the present disclosure, the longest side of the third sub-pixel SP3 and the longest side of the internal region IR may face each other.

In an embodiment of the present disclosure, the area of the third sub-pixel SP3 and the area of the internal region IR may be equal.

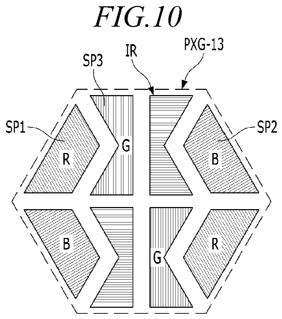

Referring to FIG. 10, in a pixel group PXG-13 according to an embodiment of the present disclosure, the first sub-pixel SP1 and the second sub-pixel SP2 may each have a trapezoidal shape, while the third sub-pixel SP3 and the internal region IR may each have a pentagonal shape like a "K" shape. In another embodiment of the present disclosure, a fourth sub-pixel (not shown) having a pentagonal shape may be disposed within the internal region IR.

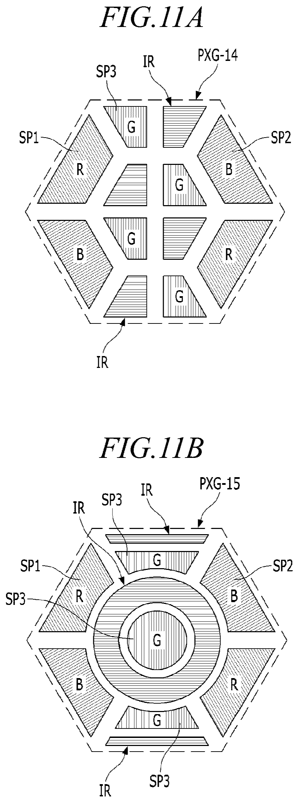

Referring to FIG. 11A, in a pixel group PXG-14 according to an embodiment of the present disclosure, the first sub-pixel SP1, the second sub-pixel SP2, the third sub-pixel SP3, and the internal region IR may each have a trapezoidal shape (e.g., isosceles trapezoidal shape in the first sub-pixel SP1 and the second sub-pixel SP2). In another embodiment of the present disclosure, a fourth sub-pixel (not shown) having a trapezoidal shape may be disposed within the internal region IR.

In an embodiment of the present disclosure, the number of third sub-pixels SP3 may differ from the number of first sub-pixels SP1, the number of second sub-pixels SP2, and the number of internal regions IR. For example, the number of third sub-pixels SP3 may be greater than the number of first sub-pixels SP1, the number of second sub-pixels SP2, and the number of internal regions IR. Since visibility is proportional to the number of third sub-pixels SP3 that emit third light, it would be possible to improve the visibility by increasing the number of third sub-pixels SP3 relative to the number of first sub-pixels SP1, second sub-pixels SP2, and internal regions IR.

Referring to FIG. 11B, in a pixel group PXG-15 according to an embodiment of the present disclosure, each of the first to third sub-pixels SP1 - SP3 may have a closed shape that includes at least one curved line (e.g., circular shape in the third sub-pixel SP3), and at least one of the internal regions IR may also have a closed shape that includes at least one curved line (e.g., a ring shape). In another embodiment of the present disclosure, at least one of the fourth sub-pixels (not shown) disposed within the internal regions IR may have a closed shape that includes at least one curved line (e.g., a ring shape).

In an embodiment of the present disclosure, one of the internal regions IR may surround one of the third sub-pixels SP3. In an embodiment, the area of one of the third sub-pixels SP3 (e.g., a circular shape) may differ from the area of another one of the third sub-pixel SP3. In an embodiment, the shape (e.g., a circular shape) of one of the third sub-pixels SP3 may differ from the shape of another one of the third sub-pixel SP3.

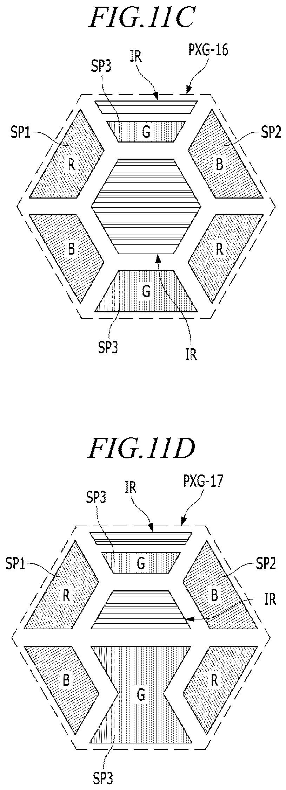

Referring to FIG. 11C, in a pixel group PXG-16 according to an embodiment of the present disclosure, each of the first to third sub-pixels SP1 - SP3 may have a trapezoidal shape. One of the internal regions IR may have a trapezoidal shape, and another one of the internal regions IR may have a hexagonal shape. In another embodiment of the present disclosure, one of the fourth sub-pixels (not shown) disposed in the internal regions IR may have a rectangular shape, and another one of the fourth sub-pixels may have a hexagonal shape.

In an embodiment of the present disclosure, the area of one of the internal regions IR may differ from the area of another one of the internal regions IR. In an embodiment, the shape of one of the internal regions IR may differ from the area of another internal region IR.

Referring to FIG. 11D, in a pixel group PXG-17 according to an embodiment of the present disclosure, the first sub-pixel SP1 and the second sub-pixel SP2 may each have a trapezoidal shape. One of the third sub-pixels SP3 may have a trapezoidal shape while another one of the third sub-pixels SP3 may have a hexagonal shape. The internal regions IR may each have a trapezoidal shape. In another embodiment of the present disclosure, the fourth sub-pixels (not shown) disposed in the internal regions IR may each have a trapezoidal shape.

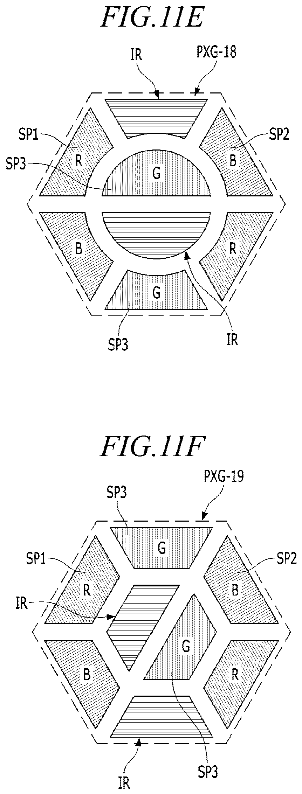

Referring to FIG. 11E, in a pixel group PXG-18 according to an embodiment of the present disclosure, the first sub-pixel SP1 and the second sub-pixel SP2 may each have a closed shape that includes at least one curved line. The internal regions IR may also each have a closed shape that includes at least one curved line. Each of the third sub-pixels SP3 may have a closed shape that includes at least one curved line. In another embodiment of the present disclosure, the fourth sub-pixels (not shown) disposed in the internal regions IR may each have a closed shape that includes at least one curved line.

In an embodiment of the present disclosure, one of the third sub-pixels SP3 and one of the internal regions IR may be a semicircular shape.

Referring to FIG. 11F, in a pixel group PXG-19 according to an embodiment of the present disclosure, the first sub-pixel SP1, the second sub-pixel SP2, the third sub-pixel SP3, and the internal region IR may each have a trapezoidal shape. In another embodiment of the present disclosure, the fourth sub-pixels (not shown) disposed in the internal regions IR may also have a trapezoidal shape.

In an embodiment of the present disclosure, the first sub-pixel SP1, the second sub-pixel SP2, the third sub-pixel SP3, and the internal region IR may have the same area. In an embodiment, the first sub-pixel SP1, the second sub-pixel SP2, the third sub-pixel SP3, and the internal region IR may have the same shape.

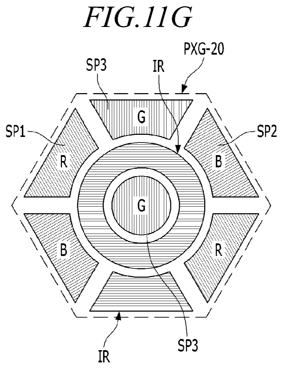

Referring to FIG. 11G, in a pixel group PXG-20 according to an embodiment of the present disclosure, the first sub-pixel SP1, the second sub-pixel SP2, and the third sub-pixel SP3 may each have a closed shape that includes at least one curved line. The internal regions IR may also each have a closed shape that includes at least one curved line. In another embodiment of the present disclosure, the fourth sub-pixels (not shown) disposed in the internal regions IR may each have a closed shape that includes at least one curved line.

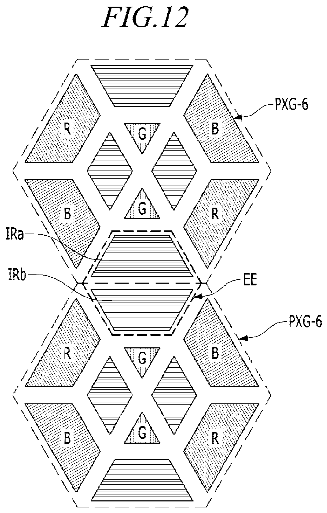

FIG. 12 is an example illustration of pixel groups PXG-6 arranged adjacent to each other.

Referring to FIGS. 8A and 12, two internal regions IRa, IRb of the two pixel groups PXG-6 may be arranged adjacent to each other within a predetermined area EE, in which at least one of a predetermined material MT, a sensor SS, and a fourth sub-pixel SP4 may be disposed. That is, since the two internal regions IRa, IRb are arranged adjacent to each other, it is possible to provide sufficient space for disposing at least one of the predetermined material MT, the sensor SS, and the fourth sub-pixel SP4. Even when the pixel groups PXG-7, PXG-8, PXG-15 shown in FIGS. 8B, 8C, and 11B are provided in plurality, substantially the same effects as described above can be achieved.

While certain embodiments of the present disclosure have been described above, anyone ordinarily skilled in the art to which the present disclosure pertains shall appreciate that there may be a variety of modifications and permutations of the present disclosure without departing from the technical ideas and scopes of the present disclosure that are defined in the appended claims. Moreover, it shall be appreciated that the disclosed embodiments are not intended to restrict the present disclosure thereto and that every technical idea within the appended claims and their equivalents is interpreted to be included in the scope of the present disclosure.

Embodiments are set out in the following clauses:
Clause 1. A display panel comprising:
   a plurality of upper pixels and a plurality of lower pixels,
   wherein each of the plurality of upper pixels and each of the plurality of lower pixels comprise:
      a first sub-pixel, which emits first light;
      a second sub-pixel, which emits second light; and
      a third sub-pixel, which emits third light, the third light having a wavelength longer than a wavelength of the first light and shorter than a wavelength of the second light,
   wherein a distance between two closest first sub-pixels among the plurality of first sub-pixels is defined as a first distance, a distance between two closest second sub-pixels among the plurality of second sub-pixels is defined as a second distance, and a distance between two closest third sub-pixels among the plurality of third sub-pixels is defined as a third distance,
   wherein each of the first distance and the second distance is shorter than the third distance,
   wherein an internal region is defined between the two closest third sub-pixels, and
   wherein no light or fourth light is emitted from the internal region, and the fourth light is different from the first light, the second light, and the third light.
Clause 2. The display panel according to clause 1, further comprising at least one of a predetermined material, a sensor, and a fourth sub-pixel,
   wherein at least one of the predetermined material, the sensor, and the fourth sub-pixel is disposed in the internal region,
   wherein the predetermined material is configured to transmit at least a portion of incident light, and
   wherein the fourth sub-pixel is configured to emit the fourth light.
Clause 3. The display panel according to clause 1 or clause 2, wherein each of the plurality of upper pixels and the plurality of lower pixels further comprises a fourth sub-pixel, which emits the fourth light, and
   wherein at least one of the plurality of fourth sub-pixels is disposed in the internal region.
Clause 4. The display panel according to any of clauses 1 to 3, wherein a first upper pixel among the plurality of upper pixels is closest to a first lower pixel among the plurality of lower pixels, and the first upper pixel and the first lower pixel are disposed within a first pixel group region having a hexagonal shape,
   wherein a second upper pixel among the plurality of upper pixels is closest to a second lower pixel among the plurality of lower pixels, and the second upper pixel and the second lower pixel are disposed within a second pixel group region having a hexagonal shape, and
   wherein a third upper pixel among the plurality of upper pixels is closest to a third lower pixel among the plurality of lower pixels, and the third upper pixel and the third lower pixel are disposed within a third pixel group region having a hexagonal shape.
Clause 5. The display panel according to clause 4, wherein the first upper pixel is disposed between the first lower pixel and the third lower pixel, and the third lower pixel is disposed between the first upper pixel and the third upper pixel.

## Claims

1. A display panel (DP) comprising:
a first pixel group (PXG1), a second pixel group (PXG2), and a third pixel group (PXG3), which are adjacent to each other,
wherein a plurality of sub-pixel regions (SR) not overlapping each other in a plan view are defined in each of the first, second, and third pixel groups (PXG1, PXG2, PXG3),
wherein, among the plurality of sub-pixel regions (SR) defined in the first pixel group (PXG1), light of different wavelengths is emitted from two closest sub-pixel regions (SR), or no light is emitted from one of the two closest sub-pixel regions (SR),
wherein, among the plurality of sub-pixel regions (SR) defined in the first pixel group (PXG1), a first sub-pixel region (SR1) is closest to a second sub-pixel region (SR2) among the plurality of sub-pixel regions (SR) defined in the second pixel group (PXG2),
wherein a same light of first light and second light is emitted from each of the first sub-pixel region (SR1) defined in the first pixel group (PXG1) and the second sub-pixel region (SR2) defined in the second pixel group (PXG2),
wherein, among the plurality of sub-pixel regions (SR) defined in the first pixel group (PXG1), a third sub-pixel region (SR3) is closest to a fourth sub-pixel region among the plurality of sub-pixel regions (SR) defined in the third pixel group (PXG3),
wherein the third sub-pixel region (SR3) is configured to emit third light,
wherein no light or fourth light is emitted from the fourth sub-pixel region, and
wherein a wavelength of the third light is longer than a wavelength of the first light and shorter than a wavelength of the second light, and the fourth light is different from the first light, the second light, and the third light.

2. The display panel (DP) according to claim 1, wherein the first pixel group (PXG1) comprises a first upper pixel (TPX1) and a first lower pixel (BPX1) facing each other, the second pixel group (PXG2) comprises a second upper pixel (TPX2) and a second lower pixel (BPX2) facing each other, and the third pixel group (PXG3) comprises a third upper pixel (TPX3) and a third lower pixel (BPX3) facing each other,
wherein each of the first to third upper pixels (TPX1, TPX2, TPX3) and each of the first to third lower pixels (BPX1, BPX2, BPX3) comprises first to third sub-pixels (SP1, SP2, SP3),
wherein the first sub-pixel (SP1) is configured to emit the first light, the second sub-pixel (SP2) is configured to emit the second light, and the third sub-pixel (SP3) is configured to emit the third light,
wherein the first sub-pixel (SP1) of the first upper pixel (TPX1) and the first sub-pixel (SP1) of the second lower pixel (BPX1) are arranged in the first sub-pixel region (SR1) and the second sub-pixel region (SR2), respectively, or the second sub-pixel (SP2) of the first upper pixel (TPX1) and the second sub-pixel (SP2) of the second lower pixel (BPX2) are arranged in the first sub-pixel region (SR1) and the second sub-pixel region (SR2), respectively,
wherein the third sub-pixel (SP3) of the first upper pixel (TPX1) is arranged in the third sub-pixel region (SR3),
wherein at least one of the plurality of sub-pixel regions (SR) of each of the first upper pixel (TPX1), the first lower pixel (BPX1), the second upper pixel (TPX2), the second lower pixel (BPX2), the third upper pixel (TPX3), and the third lower pixel (BPX3) is an internal region (IR),
wherein no light or the fourth light is emitted from the internal region (IR), and
wherein the fourth sub-pixel region is the internal region (IR) of the third lower pixel (BPX3).

3. The display panel (DP) according to claim 2, further comprising at least one of a predetermined material (MT), a sensor (SS), and a fourth sub-pixel (SP4),
wherein at least one of the predetermined material (MT), the sensor (SS), and the fourth sub-pixel (SP4) is disposed in the internal region (IR),
wherein the predetermined material (MT) is configured to transmit at least a portion of incident light, and
wherein the fourth sub-pixel (SP4) is configured to emit the fourth light.

4. The display panel (DP) according to claim 2 or claim 3, wherein each of the first to third upper pixels (TPX1, TPX2, TPX3) and each of the first to third lower pixels (BPX1, BPX2, BPX3) further comprise a fourth sub-pixel (SP4), and
wherein the fourth sub-pixel (SP4) is configured to emit the fourth light and is disposed in the internal region (IR).

5. The display panel (DP) according to any preceding claim, wherein the first pixel group (PXG1) is disposed within a first pixel group region (GR1) having a hexagonal shape,
wherein the second pixel group (PXG2) is disposed within a second pixel group region (GR2) having a hexagonal shape, and
wherein the third pixel group (PXG3) is disposed within a third pixel group region (GR3) having a hexagonal shape.

6. The display panel (DP) according to any of claims 2-5, wherein the first upper pixel (TPX1) is disposed between the first lower pixel (BPX1) and the third lower pixel (BPX3), and the third lower pixel (BPX3) is disposed between the first upper pixel (TPX1) and the third upper pixel (TPX3).

7. A display panel (DP) comprising:
a plurality of upper pixels (TPX) and a plurality of lower pixels (BPX),
wherein each of the plurality of upper pixels (TPX) and each of the plurality of lower pixels (BPX) comprise:
a first sub-pixel (SP1), which emits first light;
a second sub-pixel (SP2), which emits second light; and
a third sub-pixel (SP3), which emits third light, the third light having a wavelength longer than a wavelength of the first light and shorter than a wavelength of the second light,
wherein a distance between two closest first sub-pixels (SP1) among the plurality of first sub-pixels (SP1) is defined as a first distance (DT1), a distance between two closest second sub-pixels (SP2) among the plurality of second sub-pixels (SP2) is defined as a second distance (DT2), and a distance between two closest third sub-pixels (SP3) among the plurality of third sub-pixels (SP3) is defined as a third distance (DT3),
wherein each of the first distance (DT1) and the second distance (DT2) is shorter than the third distance (DT3),
wherein an internal region (IR) is defined between the two closest third sub-pixels (SP3), and
wherein no light or fourth light is emitted from the internal region (IR), and the fourth light is different from the first light, the second light, and the third light.

8. An electronic device (DD) comprising:
a display panel (DP), a processor (PR), a memory (MM), and a power module (PM),
wherein the display panel (DP) comprises:
a first upper pixel (TPX1), a first lower pixel (BPX1), a second lower pixel (BPX2), and a third lower pixel (BPX3),
wherein each of the first upper pixel (TPX1), the first lower pixel (BPX1), the second lower pixel (BPX2), and the third lower pixel (BPX3) comprises a first sub-pixel (SP1), which emits first light, a second sub-pixel (SP2), which emits second light, and a third sub-pixel (SP3), which emits third light, and the third light has a wavelength longer than a wavelength of the first light and shorter than a wavelength of the second light,
wherein an internal region (IR) is defined in each of the first upper pixel (TPX1), the first lower pixel (BPX1), the second lower pixel (BPX2), and the third lower pixel (BPX3),
wherein no light or fourth light is emitted from the internal region (IR), and the fourth light is different from the first light, the second light, and the third light,
wherein the first sub-pixel (SP1) of the first upper pixel (TPX1) is positioned to face the second sub-pixel (SP2) of the first lower pixel (BPX1), the second sub-pixel (SP2) of the first upper pixel (TPX1) is positioned to face the first sub-pixel (SP1) of the first lower pixel (BPX1), and the internal region (IR) defined in the first upper pixel (TPX1) is positioned to face the third sub-pixel (SP3) of the first lower pixel (BPX1),
wherein the first sub-pixel (SP1) of the first upper pixel (TPX1) is positioned to face the first sub-pixel (SP1) of the second lower pixel (BPX2), or the second sub-pixel (SP2) of the first upper pixel (TPX1) is positioned to face the second sub-pixel (SP2) of the second lower pixel (BPX2), and
wherein the third sub-pixel (SP3) of the first upper pixel (TPX1) is positioned to face the internal region (IR) of the third lower pixel (SP3).

9. The electronic device (DD) according to claim 8, further comprising at least one of a predetermined material (MT), a sensor (SS), and a fourth sub-pixel (SP4),
wherein at least one of the predetermined material (MT), the sensor (SS), and the fourth sub-pixel (SP4) is disposed in the internal region (IR),
wherein the predetermined material (MT) is configured to transmit at least a portion of incident light, and
wherein the fourth sub-pixel (SP4) is configured to emit the fourth light.

10. The electronic device (DD) according to claim 8 or claim 9, wherein each of the first upper pixel (TPX1), the first lower pixel (BPX1), the second lower pixel (BPX2), and the third lower pixel (BPX3) further comprises a fourth sub-pixel (SP4), and
wherein the fourth sub-pixel (SP4) is configured to emit the fourth light and is disposed in the internal region (IR).

11. The electronic device (DD) according to any of claims 8-10, further comprising:
a second upper pixel (TPX2) and a third upper pixel (TPX3),
wherein the first upper pixel (TPX1) is positioned to face the first lower pixel (BPX1),
wherein the first upper pixel (TPX1) and the first lower pixel (BPX1) are disposed within a first pixel group region (GR1) having a hexagonal shape,
wherein the second upper pixel (TPX2) is positioned to face the second lower pixel (BPX2),
wherein the second upper pixel (TPX2) and the second lower pixel (BPX2) are disposed within a second pixel group region (GR2) having a hexagonal shape,
wherein the third upper pixel (TPX3) is positioned to face the third lower pixel (BPX3), and
wherein the third upper pixel (TPX3) and the third lower pixel (BPX3) are disposed within a third pixel group region (GR3) having a hexagonal shape.

12. The electronic device (DD) according to claim 11, wherein the first upper pixel (TPX1) is disposed between the first lower pixel (BPX1) and the third lower pixel (BPX3), and the third lower pixel (BPX3) is disposed between the first upper pixel (TPX1) and the third upper pixel (TPX3).
